# DEMANDE DE BREVET EUROPEEN

(11) **EP 0 612 101 A1**
(43) Date de publication de la demande: **24.08.1994**
(21) Numéro de dépôt: 94400298.9
(22) Date de dépôt: 11.02.1994
(51) Int. Cl.: H01L 21/00, C23C 14/50

(54) **Dispositif de sélection pour amener un objet, par exemple un substrat, à une station de traitement**

(30) Priorité: 15.02.1993 FR 9301682
(71) Demandeur: FRANCE TELECOM, F-75015 Paris (FR)
(72) Inventeur: Gentric, Alain, F-22220 Treguier (FR)
(74) Mandataire: Casalonga, Axel

(57) **Abrégé**

Dispositif de sélection (1) permettant d'amener au moins un objet, par exemple un substrat, à une station de traitement (23), comprenant un porte-objets (16) monté tournant sur un support (3) et présentant des zones (22) de réception d'objets à traiter susceptibles d'être amenées successivement à ladite station de traitement, un organe d'accumulation de force (19) relié audit porte-objets et tendant à faire tourner ce porte-objets dans un sens, un mécanisme d'incrémentation (26) qui présente d'une part des moyens d'arrêt (27) prévus sur ledit support et d'autre part des moyens formant butées (33) prévus sur ledit porte-objets et respectivement associés audites zones de réception, lesdits moyens d'arrêt pouvant coopérer successivement avec lesdits moyens formant butées pour maintenir ledit plateau (16) à des positions successives telles que lesdites zones de réception se situent successivement à ladite station de traitement, et des moyens de déclenchement (38) venant agir sur le mécanisme d'incrémentation (26) pour que lesdits moyens d'arrêt passe sélectivement d'un moyen formant butée au moyen formant butée suivant, après rotation dudit porte-objets sous l'effet dudit organe d'accumulation de force (19).

## Description

La présente invention concerne un dispositif de sélection permettant d'amener au moins un objet, par exemple un substrat, à une station de traitement.

Le dispositif de l'invention peut en particulier s'appliquer au domaine des installations de dépôt sous vide permettant notamment la production de couches minces optiques, électroniques ou optoélectroniques, en vue de traitements de surfaces notamment de fibres optiques et éléments associés tels qu'émetteurs, récepteurs, amplificateurs, raccordements, commutateurs.

Actuellement, pour le traitement de substrats dans une enceinte à vide, on équipe ces enceintes d'un sas relié à des moyens de pompage et les substrats sont transférés du sas à la zone de traitement dans l'enceinte et réciproquement grâce à une canne de transfert. De telles installations sont très complexes, volumineuses et difficilement compatibles avec les équipements de contrôle optique des substrats, les rendant particulièrement onéreuses. De plus, les temps de traitement des substrats, compte tenu des différents types de dépôts susceptibles d'être effectués, sont particulièrement longs.

L'un des buts de l'invention est de proposer un dispositif de sélection de structure relativement simple, qui permet d'augmenter assez considérablement les cadences de traitement des objets à traiter, notamment lorsque les traitements sont différents.

Le dispositif de sélection selon l'invention, qui permet d'amener au moins un objet, par exemple un substrat, à une station de traitement, comprend un porte-objets monté tournant sur un support et présentant des zones de réception d'objets à traiter susceptibles d'être amenés successivement à ladite station de traitement, un organe d'accumulation de force relié audit porte-objets et tendant à faire tourner ce porte-objets dans un sens, un mécanisme d'incrémentation qui présente d'une part des moyens d'arrêt prévus sur ledit support et d'autre part des moyens formant butées prévus sur ledit porte-objets et respectivement associés auxdites zones de réception, lesdits moyens d'arrêt pouvant coopérer successivement avec lesdits moyens formant butées pour maintenir ledit plateau à des positions successives telles que lesdites zones de réception se situent successivement à ladite station de traitement, et des moyens de déclenchement venant agir sur le mécanisme d'incrémentation pour que lesdits moyens d'arrêt passent sélectivement d'un moyen formant butée au moyen formant butée suivant, après rotation dudit porte-objets sous l'effet dudit organe d'accumulation de force.

Dans une exécution préférée de l'invention, le mécanisme d'incrémentation précité peut avantageusement comprendre une ancre à échappement qui comprend un balancier monté pivotant sur ledit support et présentant deux doigts susceptibles de venir coopérer alternativement avec des butées dudit porte-objets, ce balancier étant soumis à un ressort agissant de façon à amener l'un des doigts en avant de l'une des butées dudit porte-objets, lesdits moyens de déclenchement agissant à l'encontre de ce ressort de façon à amener l'autre doigt en avant d'une autre butée dudit porte-objets.

Selon l'invention, ledit porte-objets comprend de préférence un plateau à la périphérie duquel sont prévues lesdites butées.

Selon l'invention, ledit organe d'accumulation de force peut avantageusement comprendre un ressort en spirale relié à des moyens de tension rotatifs.

Selon l'invention, ledit support peut avantageusement être monté de façon amovible sur un bâti.

Selon l'invention, ledit support et ledit bâti comprennent de préférence des moyens d'accouplement par rotation.

Selon l'invention, ledit support peut avantageusement être monté tournant sur un bâti, le dispositif comprenant de préférence des moyens pour entraîner en rotation ce plateau-support.

Selon l'invention, ledit support est de préférence monté tournant sur ledit bâti par l'intermédiaire des moyens qui l'entraînent en rotation.

Dans une variante de réalisation, lesdits moyens de déclenchement peuvent comprendre un doigt mobile susceptible d'être amené sur le parcours d'une partie dudit bras afin de faire pivoter ce bras losque ledit plateau-support tourne.

Selon l'invention, le dispositif peut en outre comprendre un couvercle amovible monté sur ledit support et enveloppant ledit mécanisme d'incrémentation, lesdits moyens de déclenchement présentant une partie qui s'étend au travers de ce couvercle.

Selon l'invention, à la station de traitement, ledit support peut avantageusement présenter au moins un passage traversant et que ledit porte-objets présente, dans ses zones de réception, au moins un passage traversant correspondant.

Selon l'invention, ledit porte-objets et ledit support comprennent de préférence respectivement un plateau, ces plateaux étant à axes parallèles décentrés.

Selon l'invention, le dispositif de sélection peut avantageusement être disposé dans une enceinte et être porté par le bâti de cette dernière.

Selon l'invention, lesdits moyens de déclenchement peuvent avantageusement présenter une partie qui s'étend au travers de la paroi de ladite enceinte.

La présente invention sera mieux comprise à l'étude d'un dispositif de sélection associé à une enceinte à vide de traitement d'objets constitués par des substrats en forme de plaquettes, décrit à titre d'exemple non limitatif et illustré par le dessin sur lequel :
- la figure 1 représente, dans une vue en perspective, un dispositif de sélection selon l'invention disposé dans une enceinte;
- la figure 2 représente une vue de dessus du dispositif de sélection représenté sur la figure 1, dans une enceinte à vide, dans une position de traitement ;
- la figure 3 représente une vue de dessus du dispositif de sélection représenté sur la figure 1, dans une position d'incrémentation ;

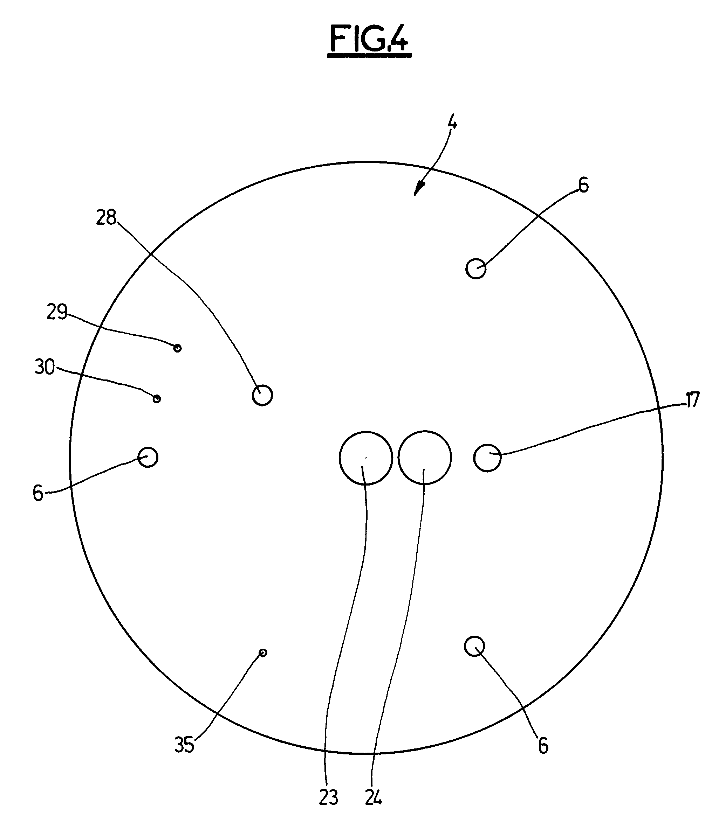

- la figure 4 représente une vue de dessus du plateau-support du dispositif de sélection précité ;
- et la figure 5 représente une coupe verticale selon V-V du dispositif de sélection de la figure 1.

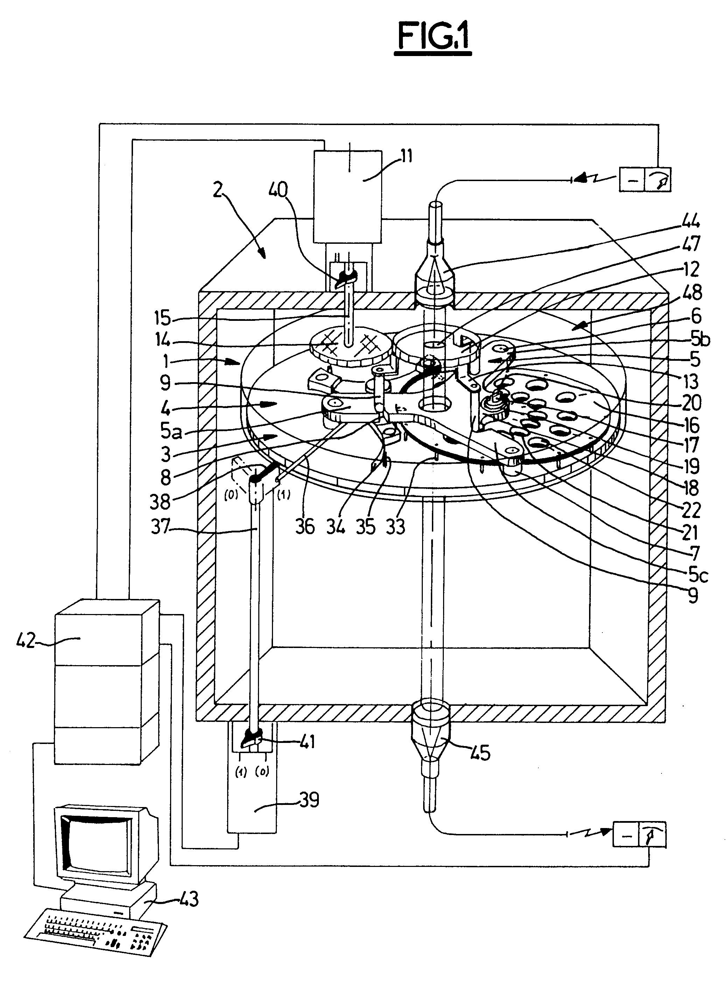

Comme le montre la figure 1, le dispositif de sélection représenté, qui est repéré d'une manière générale par la référence 1, est disposé dans une enceinte de traitement repérée d'une manière générale par la référence 2.

Le dispositif de sélection 1 est disposé dans la partie supérieure de cette enceinte 2, des appareillages de traitement non représentés étant disposés dans la partie inférieure de cette enceinte.

Le dispositif de sélection 1 comprend un support repéré d'une manière générale par la référence 3 qui comprend un plateau horizontal 4 et, au-dessus et à distance de la face supérieure de ce plateau 4, une plaque horizontale 5 à trois branches 5a, 5b et 5c d'égales longueurs et disposées à 120°. Les extrémités de ces branches, qui sont au voisinage du bord du plateau 4, sont fixées à ce dernier par trois vis 6, trois entretoises 7 étant disposées autour de ces vis 6, entre la plaque 5 et le plateau 4. Les vis 6 sont disposées à 120° par rapport au centre du plateau 4 et à faible distance du bord de ce dernier.

Les branches de la plaque 5 présentent des encoches 8 dans lesquelles peuvent être introduites par rotation selon l'axe vertical du plateau 4 les parties inférieures de trois colonnes de suspension 9, ces colonnes 9 présentant des épaulements annulaires inférieurs 9a qui sont engagés dans les encoches 8 et sur lesquels prend appui la plaque horizontale 5.

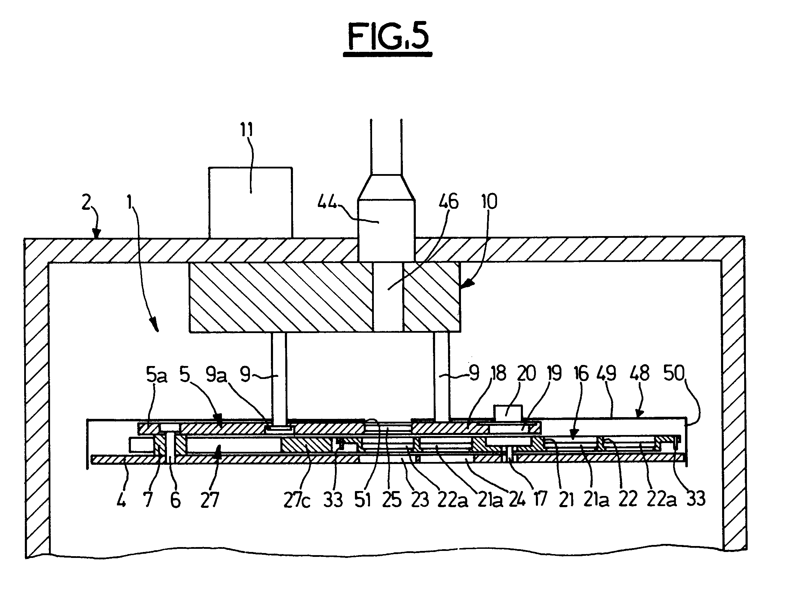

Comme représenté schématiquement sur la figure 5, les parties supérieures des colonnes 9 sont montées sur un mécanisme d'entraînement repéré d'une manière générale par la référence 10, qui est fixé sur la paroi supérieure de l'enceinte 2, à l'intérieur de cette dernière. Ce mécanisme d'entraînement 10 est relié à un moteur électrique 11 également fixé à la paroi supérieure de l'enceinte 2 mais disposé à l'extérieur de cette dernière.

Comme on le voit sur la figure 1, le mécanisme d'entraînement 10 peut comprendre, monté dans un carter, une première roue creuse dentée 12 concentrique au plateau 4 et munie à sa périphérie et sur son côté inférieur de trois pattes 13 sur lesquelles sont fixées les extrémités supérieures des colonnes 9, ainsi qu'une seconde roue dentée 14 fixée à l'extrémité inférieure de l'axe d'entraînement 15 du moteur électrique 11.

Le dispositif de sélection 1 comprend en outre un porte-plaquettes constitué par un plateau horizontal 16 qui est disposé entre le plateau horizontal 4 et la plaque horizontale 5, à distance de la face supérieure de ce plateau 4.

Le plateau 16 est fixé à un axe vertical 17 dont l'extrémité inférieure est portée par le plateau 4 et dont l'extrémité supérieure est portée par une partie 18 de la plaque 5 en saillie horizontale entre les branches 5b et 5c de cette dernière. Cette partie en saillie 18 constitue une quatrième branche courte opposée à la branche 5a.

L'axe 17 est relié à la plaque 5 par l'intermédiaire d'un organe d'accumulation de force 19 constitué en exemple par un ressort en spirale et d'un remontoir à anti-retour qui présente un bouton de manoeuvre 20.

Dans l'exemple, le diamètre du plateau 16 est sensiblement égal à 0,6 fois le diamètre du plateau 4, le bord périphérique du plateau 16 s'étendant sensiblement tangentiellement au bord du plateau 4.

Ainsi, le plateau 16 s'étend sous les branches 5b et 5c de la plaque 5, entre les entretoises qui portent ces branches, et sous la partie centrale de cette plaque.

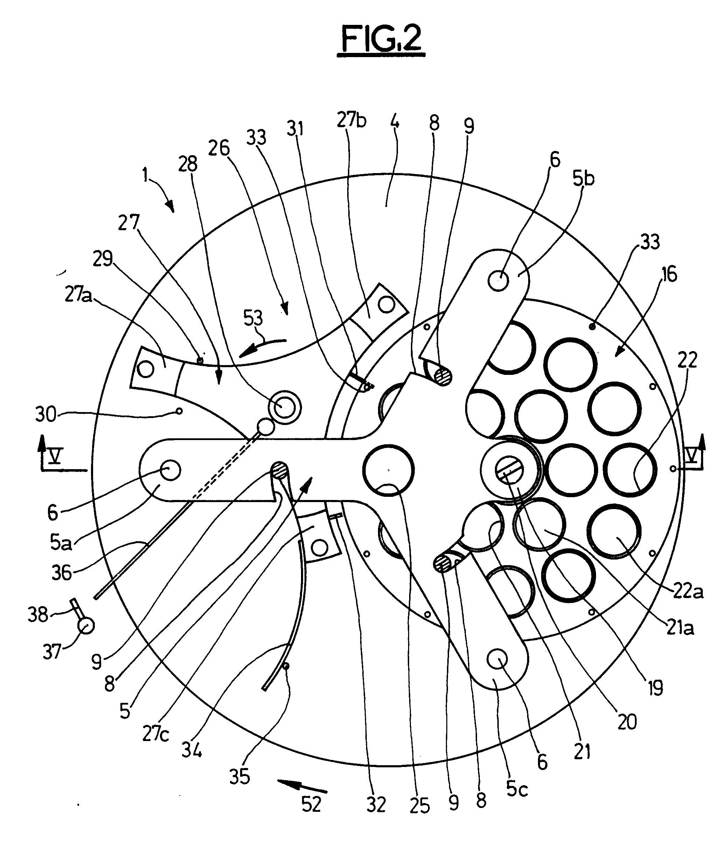

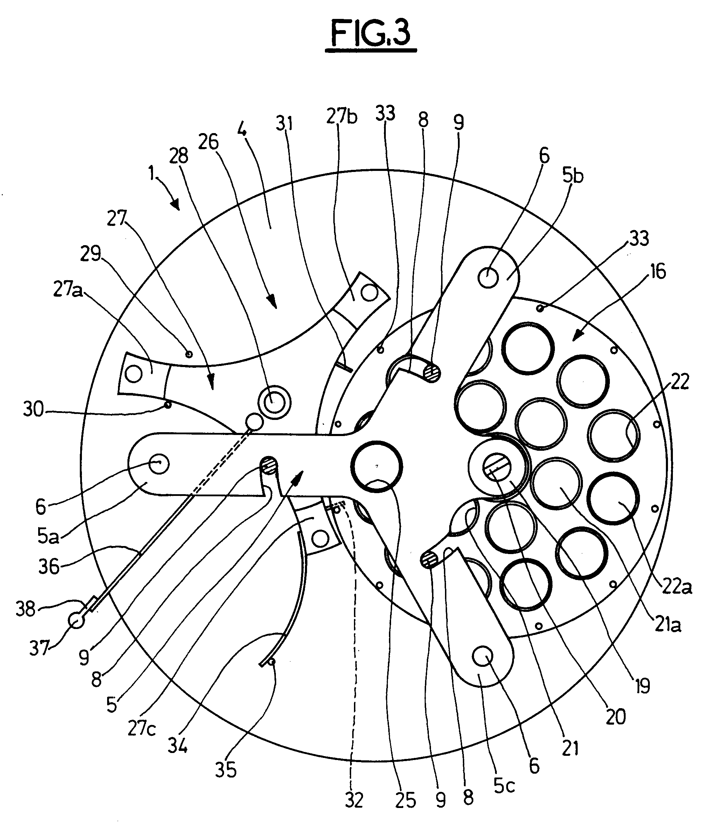

Le plateau 16 présente des zones de réception de plaquettes qui sont constituées dans l'exemple par deux rangées concentriques de passages traversants 21 et 22. Dans l'exemple représenté sur les figures 2 et 3, la rangée intérieure présente six passages traversants 21 et la rangée extérieure présente douze passages traversants 22, qui sont régulièrement répartis, les passages traversants 21 étant sur le même rayon que six passages traversants correspondants 22 de la rangée extérieure.

Dans les passages traversants 21 et 22 sont prévus, par exemple, des épaulements ou des ergots de manière à pouvoir y disposer par-dessus et maintenir des plaquettes circulaires 21a et 22a.

Le plateau 4 présente, dans sa partie centrale, un passage traversant 23 au regard duquel peuvent être amenés successivement, par rotation du plateau 16, les passages traversants 22 de la rangée extérieure précitée, ainsi qu'un passage traversant 24 situé entre le passage traversant 23 et l'axe 17 du plateau 16, au regard duquel peuvent être amenés successivement les passages 2 1 de la rangée intérieure précitée. En outre, la plaque horizontale 5 présente, dans sa partie centrale, un passage traversant 25 formé en correspondance au passage central 23 du plateau 4.

Le dispositif de sélection comprend en outre un mécanisme d'incrémentation à déclenchement repéré d'une manière générale par la référence 26.

Ce mécanisme 26 comprend une ancre à échappement comprenant un balancier horizontal 27 en étoile à trois branches 27a, 27b et 27c disposées à 120°. La partie centrale de ce balancier 27 est portée par un axe vertical 28 disposé d'un côté de la branche 5a de la plaque 5, dont l'extrémité inférieure est portée par le plateau 4. Le balancier 27 est disposé de telle sorte que ses branches 27b et 27c s'étendent le long et à distance du bord périphérique du plateau 16 et que sa branche 27a s'étende vers l'extérieur, sans atteindre le bord périphérique du plateau 4, sa branche 27c s'étendant en-dessous de la branche 5a de la plaque 5.

Le balancier 27 est pivotant entre deux positions extrèmes limitées par deux butées en saillie 29 et 30 qui sont situées de part et d'autre de sa branche 27a et sont portées par le plateau 4.

Les branches 27b et 27c du balancier 27 portent des doigts formant butées 31 et 32 qui s'étendent horizontalement en direction du plateau 16 et ce plateau 16 présente, à sa périphérie et en-dessous, douze doigts formant butées 33 qui sont disposés en correspondance radiale avec les passages traversants 22 du plateau 16.

Lorsque le balancier 27 est à ses positions extrèmes, les doigts 31 et 32 s'étendent respectivement sur le parcours des doigts 33 du plateau 16.

Le balancier 27 est soumis à un ressort à lame 34 qui est porté par sa branche 27c et qui est maintenu en tension par un ergot 35 monté en saillie sur le plateau 4, ce ressort 34 tendant à maintenir la branche 27a du balancier 27 contre la butée 29, le doigt 31 porté par sa branche 27a étant alors sur le parcours des doigts 33 du plateau 16.

Le balancier 27 porte un bras d'actionnement 36 constitué par un bras qui s'étend au-delà du bord périphérique du plateau 4. Le mécanisme 26 comprend en outre un axe vertical 37 qui s'étend au travers de la paroi inférieure de l'enceinte 2 et dans cette dernière au voisinage de l'une de ses parois latérales. L'extrémité supérieure de cet axe 37 porte un doigt radial 38.

L'extrémité inférieure de l'axe 37 est reliée à un organe d'actionnement électrique 39, extérieure à l'enceinte 2, qui peut faire tourner cet axe 37 entre deux positions extrèmes. Dans l'une de ces positions, le doigt 38 est en dehors du parcours de l'extrémité extérieure du bras 36 porté par le balancier 27 et dans son autre position extrème, le doigt 38 est sur le parcours de l'extrémité extérieure de ce bras 36.

Comme on le voit sur la figure 1, l'axe 15 du moteur 11 est équipé, à l'extérieur de l'enceinte 2, d'un détecteur de position angulaire 40, et l'arbre 37 est équipé, à l'extérieur de l'enceinte 2, d'un détecteur 41 de ses deux positions extrèmes précitées.

Le moteur 11, l'organe d'actionnement 39 et les détecteurs 40 et 41 sont reliés à un ensemble électronique de commande 42 relié à une unité de programmation 43.

Enfin, les parois supérieure et inférieure de l'enceinte 2 sont équipées respectivement d'un émetteur 44 d'un faisceau de contrôle et d'un récepteur 45 de ce faisceau qui sont également reliés à l'ensemble électronique 42. L'émetteur 44 et le récepteur 45 sont disposés de telle sorte que le faisceau s'étende coaxialement au plateau 4 et passe au travers d'un passage vertical 46 représenté schématiquement sur la figure 5, et au travers des passages traversants 25 et 23 de la plaque horizontale 5 et du plateau 4. Dans l'exemple représenté sur la figure 1, la roue dentée 12 du mécanisme d'entraînement 10 présente un passage central 47 pour le passage du faisceau précité.

Comme le montrent schématiquement les figures 1 et 5, le dispositif de sélection 1 comprend une enveloppe de protection ou couvercle 48 en forme de cuvette inversée qui présente un fond plat horizontal 49 qui vient en appui sur la face supérieure de la plaque 5 et une paroi cylindrique 50 qui s'étend vers le bas et qui enveloppe à faible distance le bord périphérique du plateau 4. Le fond 49 présente un passage central 51 pour le passage du faisceau précité ainsi que des passages pour les trois colonnes 9 et un passage pour le bouton 20 de l'organe d'accumulation de force 19.

Le dispositif de sélection 1 qui vient d'être décrit fonctionne et peut être utilisé de la manière suivante.

En position statique telle que représentée sur la figure 2, le balancier 27 est maintenu, sous l'effet du ressort 34, dans une position telle que sa branche 27 est en appui contre la butée 29 portée par le plateau 4 et le doigt 31 porté par sa branche 27b est en avant de l'un des doigts 33 portés par le plateau 16, ce doigt étant maintenu en appui contre le doigt 31 sous l'effet de l'organe d'accumulation de force 19.

Dans cette position, l'un des passages traversants 22a du plateau 16 est situé au regard du passage traversant central 23 du plateau 4 et éventuellement l'un des passages traversants 21 du plateau 16 est situé au regard du passage 24 du plateau 4. Le dispositif de sélection 1 se trouve ainsi dans une position pour le traitement des plaquettes 21a et 22a disposées dans les passages traversants 21 et 22 situés en face des passages traversants 24 et 23 du plateau 4, ces passages 23 et 24 constituant une station de traitement.

Lors de l'opération de traitement, par exemple une opération de dépôt sur les faces inférieures des plaquettes 21a et 22a, on peut, grâce au moteur électrique 11, faire tourner le support 3, constitué du plateau 4 et de la plaque 5, suspendu aux colonnes 9. Cette rotation a pour but d'homogénéiser le dépôt précité.

Au fur et à mesure du dépôt, on peut en outre, grâce au faisceau émis par l'émetteur 44 et capté par le récepteur 45, surveiller le traitement effectué. Pour celà les plaquettes 22a doivent être choisies en un matériau transparent au faisceau précité, ces plaquettes constituant des plaquettes témoins.

Le doigt de déclenchement 38 étant en dehors du parcours de la partie extérieure du bras 36 relié au balancier 27, le dispositif de sélection 1 peut effectuer plusieurs tours.

Pour faire tourner le plateau 16 de manière à amener d'autres passages traversants 21 et 22 en face des passages traversants 23 et 24 du plateau 4 afin de traiter d'autres plaquettes, on peut procéder de la manière suivante.

On active l'organe d'actionnement 39 de manière à amener le doigt 38 que porte l'axe vertical 37 sur le parcours de l'extrémité extérieure du bras 36 porté par le balancier 27. On fait tourner le support 3 en actionnant le moteur 11 dans le sens de la flèche 52. Lorsque l'extrémité extérieure du bras 36 rencontre le doigt de déclenchement 38, elle se trouve retenue et ce bras 36 provoque la rotation du balancier 27 dans le sens contraire du sens de rotation du plateau 4, comme l'indique la flèche 53, jusqu'à ce que la branche 27a de ce balancier vienne en appui contre la butée 30.

Dans cette position visible sur la figure 3, le doigt 31 du balancier 27 libère le doigt 33 du plateau 16 qui était en appui dessus et le doigt 32 du balancier 27 vient en avant du parcours des doigts 33. Sous l'effet de l'organe d'accumulation de force 19, le plateau 16 tourne jusqu'à ce que l'un des doigts 33 du plateau 16 vienne en arrêt contre ce doigt 32. Le plateau 16 a alors tourné d'un vingt quatrième de tour, soit d'un demi incrément.

La partie extérieure du bras 36 ayant passée au-dessus de la butée de déclenchement 38, le balancier 27 est libéré et, sous l'effet du ressort 34, pivote dans le sens opposé à la flèche 53 et revient en appui contre la butée 29. Le doigt 32 libère le doigt 33 du plateau 16 qui était en appui dessus et le doigt suivant 33 du plateau 16 vient en appui contre le doigt 31 du balancier 27.

Lors de ce mouvement d'aller-retour du balancier 27, le plateau 16 a, sous l'effet de l'organe d'accumulation de force 19, pivoté d'un douzième de tour, soit d'un incrément, de telle sorte que le passage traversant 22 suivant du plateau 16 est en regard du passage traversant 23 du plateau 4.

On peut alors procéder au traitement comme décrit précédemment des plaquettes qui se trouvent dans les passages traversants nouvellement amenés en face des orifices traversants 23 et 24 du plateau 4.

Grâce au dispositif de sélection 1, il est possible de procéder à des traitements différents sur des plaquettes 21a, 22a différentes, asssociés aux différentes positions du plateau 16.

Dans une variante d'utilisation possible, on peut grâce au moteur 11 amener le dispositif de sélection 1 dans une position détectable par le détecteur 40, telle que la partie extérieure du bras de déclenchement 36 soit amenée en face du doigt de déclenchement 38 porté par l'axe vertical 37. Dans cette position, on active l'organe d'actionnement électrique 39 de manière à faire agir le doigt de déclenchement 38 sur le bras 36 pour faire pivoter le balancier 27 dans le sens de la flèche 53 comme indiqué précédemment et on active l'organe d'actionnement 39 de manière à ramener le doigt de déclenchement 38 dans sa position écartée de manière que le balancier 27 pivote dans le sens contraire de la flèche 53 comme décrit précédemment. Lors de ce mouvement d'aller-retour du balancier 27, le plateau 16 pivote, comme précédemment décrit, d'un douzième de tour, soit d'un incrément.

Dans la variante d'utilisation décrite précédemment, il fallait que le dispositif de sélection 1 tourne d'un tour pour faire tourner le plateau 16 d'un douzième de tour. Dans cette seconde variante, le dispositif de sélection reste immobile. En faisant agir le doigt de déclenchement 38 sur le bras de déclenchement 36 relié au balancier 27, on peut faire avancer successivement le plateau 16 d'un douzième de tour le nombre de fois souhaité.

Pour procéder au déchargement des plaquettes 21a et 22a après traitement et au chargement d'autres plaquettes, on peut procéder de la manière suivante.

On ouvre la porte frontale de l'enceinte 2 non visible sur la figure 1 et, manuellement, on fait pivoter le dispositif de sélection 1 de manière à libérer les parties inférieures des colonnes 9 des encoches 8 de la plaque horizontale 5 et, manuellement et en le portant, on extrait le dispositif de sélection 1 de l'enceinte 2 pour le poser par exemple sur une table.

On dépose l'enveloppe 48 en la soulevant. On enlève les plaquettes 21a et 22a des passages traversants 21 et 22 du plateau 16, éventuellement en faisant tourner ce dernier en actionnant manuellement le bras de déclenchement 36.

On place de nouvelles plaquettes 2a et 22a dans les passages traversants 21 et 22 du plateau 16.

On manoeuvre le bouton 16 de façon à retendre le ressort à spirale de l'organe d'accumulation de force 19.

On repère les positions des plaquettes nouvellement installées par rapport aux passages traversants 23 et 2. On replace l'enveloppe ou le capot 48.

On saisit le dispositif de sélection 1 et on le remonte dans l'enceinte 2 en l'accrochant par rotation sur les extrémités inférieures des colonnes 9.

Le dispositif de sélection 1 est prêt pour procéder aux traitements souhaités des nouvelles plaquettes que son plateau 16 porte, comme on l'a décrit précédemment.

Il est bien entendu que la présente invention ne se limite pas à l'exemple ci-dessus décrit. En particulier, les nombres, dispositions et formes des passages traversants du plateau 16 pourraient être différents. Les plateaux 4 et 16 pourraient présenter des diamètres dans un rapport différent. La station de traitement constituée par les passages traversants 23 et 24 du plateau 4 pourrait être de forme différente.

## Revendications

1. Dispositif de sélection (1) permettant d'amener au moins un objet, par exemple un substrat (22a), à une station de traitement (23), caractérisé par le fait qu'il comprend
- un porte-objets (16) monté tournant sur un support (3) et présentant des zones (22) de réception d'objets à traiter susceptibles d'être amenées successivement à ladite station de traitement,
- un organe d'accumulation de force (19) relié audit porte-objets et tendant à faire tourner ce porte-objets dans un sens,
- un mécanisme d'incrémentation (26) qui présente d'une part des moyens d'arrêt (27) prévus sur ledit support et d'autre part des moyens formant butées (33) prévus sur ledit porte-objets et respectivement associés audites zones de réception, lesdits moyens d'arrêt pouvant coopérer successivement avec lesdits moyens formant butées pour maintenir ledit porte-objet (16)à des positions successives telles que lesdites zones de réception se situent successivement à ladite station de traitement,
- et des moyens de déclenchement (38) venant agir sur le mécanisme d'incrémentation (26) pour que lesdits moyens d'arrêt passe sélectivement d'un moyen formant butée au moyen formant butée suivant, après rotation dudit porte-objets sous l'effet dudit organe d'accumulation de force.

2. Dispositif selon la revendication 1, caractérisé par le fait que ledit mécanisme d'incrémentation (26) comprend une ancre à échappement qui comprend un balancier (27) monté pivotant sur ledit support (3) et présentant deux doigts (31, 32) susceptibles de venir coopérer alternativement avec des butées (33) dudit porte-objets (16), ce balancier (27) étant soumis à un ressort (34) agissant de façon à amener l'un (31) des doigts en avant de l'une des butées (33) dudit porte-objets, lesdits moyens de déclenchement (36) agissant à l'encontre de ce ressort de façon à amener l'autre (32) doigt en avant d'une autre butée dudit porte-objets.

3. Dispositif selon l'une des revendications 1 et 2, caractérisé par le fait que ledit porte-objets comprend un plateau (16) à la périphérie duquel sont prévues lesdites butées (33).

4. Dispositif selon l'une quelconque des revendications précédentes, caractérisé par le fait que ledit organe d'accumulation de force (19) comprend un ressort en spirale relié à des moyens de tension rotatifs (20).

5. Dispositif selon l'une quelconque des revendications précédentes, caractérisé par le fait que ledit support (3) est monté de façon amovible sur un bâti (3).

6. Dispositif selon la revendication 5, caractérisé par le fait que ledit support (5) et ledit bâti (2) comprennent des moyens d'accouplement par rotation (8, 9).

7. Dispositif selon l'une quelconque des revendications précédentes, caractérisé par le fait que ledit support est monté tournant sur un bâti et qu'il comprend des moyens (10) pour entraîner en rotation ce plateau-support.

8. Dispositif selon la revendication 7, caractérisé par le fait que ledit support est monté tournant sur ledit bâti par l'intermédiaire des moyens (10) qui l'entraîne en rotation.

9. Dispositif selon l'une quelconque des revendications précédentes, caractérisé par le fait que lesdits moyens de déclenchement comprennent un doigt mobile (38) susceptible d'être amené sur le parcours d'une partie dudit bras (36) afin de faire pivoter ce bras losque ledit plateau-support tourne.

10. Dispositif selon l'une quelconque des revendications précédentes, caractérisé par le fait qu'il comprend un couvercle (48) amovible monté sur ledit support (3) et enveloppant ledit mécanisme d'incrémentation, lesdits moyens de déclenchement présentant une partie qui s'étend au travers de ce couvercle.

11. Dispositif selon l'une quelconque des revendications précédentes, caractérisé par le fait qu'à la station de traitement, ledit support présente au moins un passage traversant (23) et que ledit porte-objets (16) présente, dans ses zones de réception, au moins un passage traversant correspondant (22).

12. Dispositif selon l'une quelconque des revendications précédentes, caractérisé par le fait que ledit porte-objets et ledit support comprennent respectivement un plateau, ces plateaux (4, 16) étant à axes parallèles décentrés.

13. Dispositif selon l'une quelconque des revendications précédentes, caractérisé par le fait qu'il est disposé dans une enceinte (2) et qu'il est porté par le bâti de cette dernière.

14. Dispositif selon la revendication 13, caractérisé par le fait que lesdits moyens de déclenchement présentent une partie (37) qui s'étend au travers de la paroi de ladite enceinte (2).
